# EUROPEAN PATENT SPECIFICATION

(11) **EP 0 394 480 B1**
(45) Date of publication and mention of the grant of the patent: **10.05.1995**
(21) Application number: 89911403.7
(22) Date of filing: 12.10.1989
(51) Int. Cl.: H03H 9/145, H03H 3/08

(54) **STRUCTURE OF SURFACE ACOUSTIC WAVE TRANSDUCER HAVING SMALL ELECTRODE GAPS AND METHOD OF PRODUCING THE SAME**
STRUKTUR EINES UMFORMERS VON OBERFLÄCHENWELLEN, MIT KLEINEN ELEKTRODENLÜCKEN SOWIE VERFAHREN ZUR DESSEN HERSTELLUNG
STRUCTURE D'UN TRANSDUCTEUR D'ONDES ACOUSTIQUES DE SURFACE PRESENTANT DE PETITS INTERSTICES ENTRE LES ELECTRODES, ET PROCEDE DE PRODUCTION DE CE TRANSDUCTEUR

(30) Priority: 16.10.1988 JP 260210/88
(43) Date of publication of application: 31.10.1990
(73) Proprietor: YAMANOUCHI, Kazuhiko, Miyagi 982 (JP)
(72) Inventor: YAMANOUCHI, Kazuhiko, Miyagi 982 (JP)
(74) Representative: Goddar, Heinz J., Dr.
(86) International application number: JP8901046
(87) International publication number: WO9004285

(56) References cited:
- JP-A- 5 258 383
- JP-A-61 274 415
- US-A- 4 450 374
- PATENT ABSTRACTS OF JAPAN, vol. 11, no. 81 (E-488)[2528], 12th March 1987; & JP-A-61 234 114 (TOYO COMMUN. EQUIP. CO., LTD) 18-10-1986
- PATENT ABSTRACTS OF JAPAN, vol. 7, no. 4 (E-151)[1149], 8th January 1983; & JP-A-57 162 819 (TOKYO SHIBAURA DENKI K.K.) 06-10-1982
- PATENT ABSTRACTS OF JAPAN, vol. 10, no. 145 (E-407), 28th May 1986; & JP-A-61 006 917 (KAZUHIKO YAMANOUCHI) 13-01-1986
- PATENT ABSTRACTS OF JAPAN, vol. 9, no. 315 (E-365)[2038], 11th december 1985; & JP-A-60 149 214 (HITACHI SEISAKUSHO K.K.)
- I.E.E.E. TRANSACTIONS ON ULTRASONICS, FERROELECTRICS, AND FREQUENCY CONTROL, vol. UFFC-34, no. 5, September 1987, pages 531-539, IEEE, New York, US; K. YAMANOUCHI et al.: "New-low-loss surface acoustic wave transducers in the UHF range"

## Description

The present invention relates to a structure for preventing shorts of adjacent IDT (Inter-Digital Transducer) electrode segments (including floating electrodes, meander lines, or reflector strips) in a surface acoustic wave transducer which the IDT electrode segments are closely spaced or their spacing is small as compared with the width of each electrode segment. The invention also pertains to a method for the manufacture of such a surface acoustic wave transducer.

The prior art publication "PATENT ABSTRACTS OF JAPAN, vol. 7, no 4 (E-151) [1149] 8th January 1983; & JP-A 57 162 819" discloses a structure of a surface acoustic wave transducer in which IDT electrode segments are closely spaced apart and marginal edges of adjacent electrode segments (and thus at least one) are rendered dielectric by oxidation to reduce the production of defects and to improve the yield.

As is well-known in the art, in a so-called surface acoustic wave transducer which has IDT electrodes deposited on a piezoelectric substrate and excites surface acoustic wave signal having propagated thereto and transduces it into an electric signal, the center frequency of the transducer is determined by the pitch of the IDT electrode segments. In devices employing the inter-digital transducer (hereinafter) referred to as the IDT) the width of each of the electrode segments and their spacing are usually selected substantially equal to each other for various reasons.

Today when various pieces of electronic equipment are being developed for operation at higher frequencies, center frequencies of the devices employing the IDT also need to be raised accordingly. This inevitably calls for reduction of the pitch of the electrode segments, and consequently, the corresponding reduction of the width of each segment and their spacing as well.

The deposition of such closely spaced IDT electrodes by photolithography necessitates the use of a photomask having very narrow slits, but the formation of such a photomask is very difficult and eventually raises manufacturing costs of surface acoustic wave transducers.

As a solution to this problem, the inventor of this application has proposed, in the field of a "unidirectional surface acoustic wave filter", a surface acoustic wave transducer in which the width of each electrode segment is sufficientlly larger than their spacing (see Japanese Pat. Appln. No. 22380/88).

With such a structure, however, conventional surface acoustic wave transducers using the IDT electrodes with closely spaced electrode segments still often suffer short-circuiting of adjacent electrodes during manufacture, which ruins the devices; hence they are extremely low in the yield rate of product.

It is therefore an object of the present invention to provide a surface acoustic wave transducer of a structure which is free from shortcircuiting of closely spaced electrode segments, easy to manufacture, and hence is high in the yield rate of product.

Another object of the present invention is to provide a method for the manufacture of such a surface acoustic wave transducer.

To attain the above objective, according to the present invention, marginal edges of adjoining electrode segments are separated by a metallic oxide which is a dielectric material, and the metallic oxide is selectively formed only at the marginal edges of the electrode segments in the course of manufacture of the surface acoustic wave transducer.

Accordingly, the present invention is very effective in preventing shorts of the electrode segments in the manufacture of a resonator which is required to be high in its resonance frequency or a unidirectional transducer in which the electrode segments are widened and closely spaced apart with a view to facilitating its fabrication.

With the manufacturing method of the present invention, partitions of a dielectric material can each be provided between adjacent electrode segments in the step of their formation. Further, since the IDT electrode segments are mostly formed as a unitary structure, they can be made dielectric at required positions at one time by anodic oxidation. Accordingly, the method of the present invention permits easy and low-cost fabrication of the above-mentioned transducer.

### BRIEF DESCRIPTION OF THE DRAWINGS

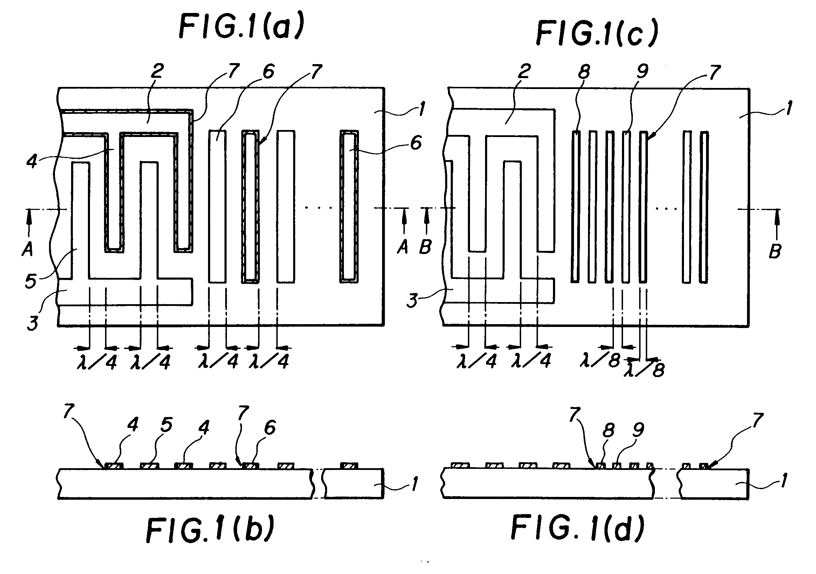

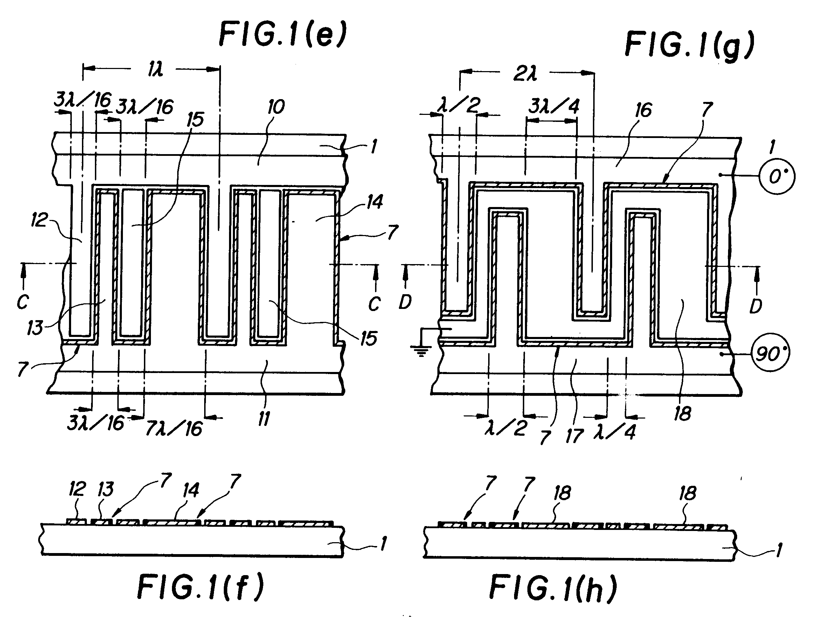

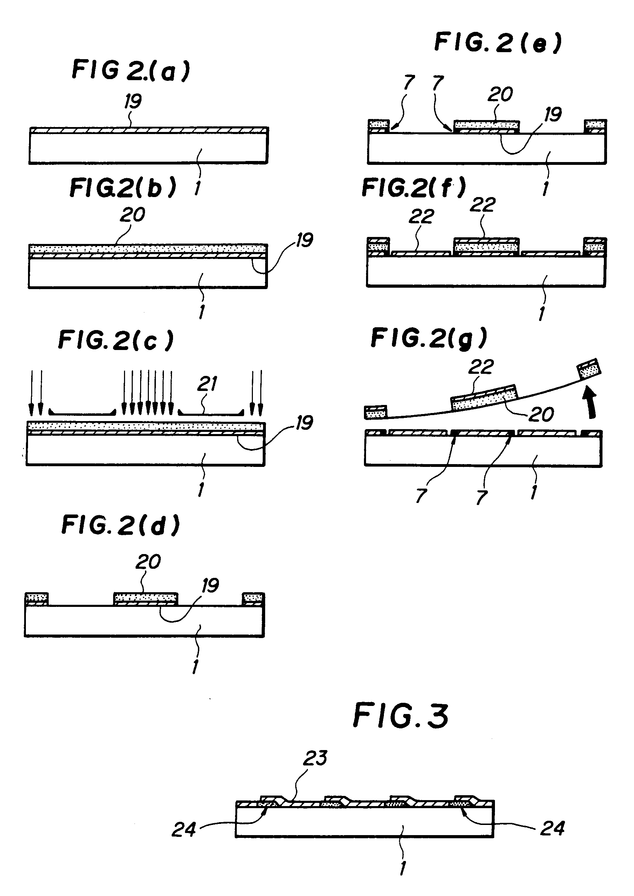

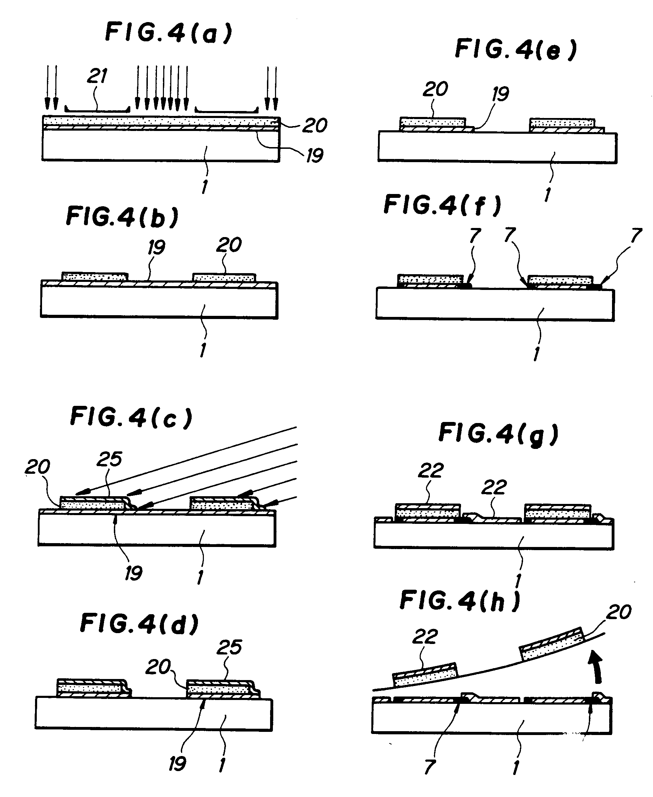

Figs. 1(a) and (b), (c) and (d), (e) and (f), and (g) and (h) are plan and sectional views respectivelly illustrating different embodiments of the surface acopustic wave transducer of the present invention; Figs. 2(a) through (g) are sectional views showing a sequence of steps involved in the manufacture of the transducers depicted in Fig. 1; Fig. 3 is a sectional view illustranting an example of an unidirectional surface acoustic wave transducer embodying the present invention; and Figs. 4(a) through (h) are sectional views showing the steps involved in producing the transducer depicted in Fig. 3.

### BEST MODE FOR CARRYING OUT THE INVENTION

The present invention will hereinafter be described in detail in connection with the embodiments shown in the drawings.

Figs. 1(a) through (h) are plain and sectional views illustrating the structures of four typical surface acoustic wave devices embodying the present invention.

Figs. 1(a) and (b) show an ordinary surface acoustic wave resonator, in which electrode segments 4, 4, ... and 5, 5, ... of a pair of IDT electrodes 2 and 3 and reflecting strips 6, 6, ... are arranqed on a piezoelectric substrate 1 in side-by-side relation in the direction of propagation of surface acoustic waves which are excited by the electrode segments 4 and 5. The electrode segments 4 and 5 and the reflecting strips 6 each have a width equal to and are spaced a distance of λ /4 (where λ is the wavelength of the excited surface acoustic waves) apart.

If the resonator of such an electrode arrangement is required to have a high resonance frequency, the widths of the electrode segments 4 and 5 and the reflecting strips 6 and their spacing will have to be reduced, and consequently, adjacent electrode segments will be more likely to short as referred to previously.

To avoid this, in the surface acoustic wave transducer (a resonator, in this instance) of the present invention marginal edges of the electrode segments 4, 4, ... of the IDT electrode 2 and half of the reflecting strips 6, 6, ... are oxidized or anodized to form metallic oxides 7, 7, ... as shown in Figs. 1(a) and (b).

Figs. 1(c) and (d) show what is called a "positive-negative reflection type surface acoustic wave resonator" in which reflector strips are slightly modified for improving the Ω of the resonator, that is, aluminum (Al) and gold (Au) strips 8 and 9 of the same width λ /8 are alternately arranged at intervals of λ /8. In this type of resonator marginal edges of only the aluminum strips 8, 8, ..., for example, may be oxidized or anodized to form the metallic oxides 7 as shown.

Figs. 1(e) and (f) show an internal reflection type unidirectional IDT employing floating electrodes, already proposed by the inventor of this application, in which IDT electrodes 10 and 11 have asymmetrical electrode segments 12, 12, ... and 13, 14 and floating electrodes 15, 15, ... each disposed between them. Owing to the asymmetry of the electrode segments, excited surface acoustic wave energies are mostly propagated in one direction. By disposing two such transducers opposite in the direction of propagation of surface acoustic waves excited by either of them (which direction is called a forward direction), a surface acoustic wave filter can be obtained which is of small insertion loss and of few ripples in its pass band.

Also in this instance, if the center frequency of the surface acoustic transducer is required to be high, the width of each electrode segment will have to be reduced, introducing difficulty in the formation of the photomask. To avoid this, the inventor of this application has proposed the transducer in which the width L of each electrode segment is increased and their spacing S is decreased correspondingly, that is, S/L < 1, or S/L « 1 in some cases, but such a transducer also suffers short-circuiting of adjacent electrode segments as mentioned previously.

The surface acoustic wave transducer of the present invention gets around this problem by oxidizing or anodizing marginal edges of the electrode segments of the one IDT electrode 11 to form the metallic oxide 7 as shown in Figs. 1(e) and (f).

Figs. 1(g) and (h) are a plain and a sectional view also showing a transdeucer embodying the present invention, called a group type unidirectional IDT, in which a conductor line 18, commonly referred to as a meander line, is disposed between a pair of IDT electrodes 16 and 17 and is grounded. In this instance, surface acoustic waves, which are excited by applying to the IDT electrodes 16 and 17 signals displaced 90 ° apart in phase, are in phase in the forward direction but 180° out of phase in the backward direction, so that the surface acoustic wave energy propagates in on direction.

Also in this case, marginal edges of the IDT electrode segments extending along the meander line 18 are oxidized or anodized to form the metallic oxide 7 for preventing short-circuiting between the electrode segments and the meander line.

The surface acoustic wave transducers described above can each be manufactured by such a method as shown in Figs. 2(a) through (g).

The manufacture starts with the deposition of a metallic film 19 all over a required area of the surface of the piezoelectric substrate 1(a), followed by coating the metallic film with a photoresist 20(b). The photoresist thus coated is exposed to light through a mask 21 having slits of required widths (c) and is developed, which is followed by etching away the exposed areas of the metallic film 19(d). The marginal edges of the metallic film 19 underlying the remaining photoresist 20 are oxidized or anodized to from the metallic oxide 7(e), after which a metallic film 22 is deposited using the remaining photoresist 20 as a mask (f), and finally, the remaining photoresist 20 and the metallic fim 22 deposited thereon are removed.

Incidentally, the metallic films 19 and 22 are usually aluminum (Al) but other metals can be used. In the case of forming the reflecting strips by different metals as depicted in Figs. 1(c) and (d), gold (Au) may be used for the metallic film 22.

Sulfuric acid is usually employed for oxidation of the aluminum (Al), and for anodic oxidation, an acid such as sulfuric acid is used in which the IDT electrodes to be anodized, for example, are disposed at the anode, with the cathode connected to an insoluble electrode (as of lead (Pb), platinum (Pt), or the like), are energized, as is well-known in the art.

Fig. 3 illustrates in section another unidirectional transducer embodying the presnt invention, which has also been proposed by the inventor of this application as is the case with the embodiment shown in Figs. 1(a) and (b). By arranging partly stepped electrode segments 23, 23, ... at the same pith, the unidirectional transducer can be obtained without the necessity of utilizing the asymmentry of IDT electrode arrangement.

In the manufacture of such a transducer, since the prior art employs sputtering by which a cavity formed by an overhang of each stepped electrode segment is filled with SiO₂ or a similar dielectric material, it is difficult to deposit the SiO₂ accurately at the desired position, and in particular, in the case where the spacing of electrode segments is very small, adjacent electrode segments are liable to short. Hence, this structure has not yet been put to practical use.

This problem can be solved by such a method as shown in Figs. 4(a) through (h).

The formation of such a transducer structure begins with deposition of the metallic film 19 and the photoresist 20 over a required area of the surface of the piezoelectric substrate 1, which is followed by exposure of the photoresist 20 to light through the mask 21 having required slits (a), after which the photoresist 20 of the exposed area is developed and removed (b). Then a material which is resistant to an etchant for removing the metallic film 19 is coatd as a thin film 25 on the remaining photoresist 20 from a direction oblique to the surface of the piezoelectric substrate 1(c). Next, the exposed portion of the initially deposited metallic film 19 is etched away (d), after which the thin film 25 deposited later is also etched away (e) so that the metallic film 19 underlying the remaining photoresist 20 slightly protrudes from thereunder.

Following this, the exposed portions of the metallic film 19 are oxidized or anodized to form the metallic oxide 7, after which the metallic film 22 is deposited using the remaining photoresist 20 as a mask (g), and finally, the remaining photoresist 20 and the metallic film 22 deposited thereon are removed. In this way, the unidirectional surface acoustic wave transducer such as shown in Fig. 3 can be manufactured relatively easily.

As the material for the thin film 25 which is deposited from the direction oblique to the surface of the piezoelectric substrate 1, chromium (Cr) would be best, if aluminum (Al) is used for the initially deposited metallic film 19. These metallic films can easily be formed by vapor deposition.

The angle for the oblique vapor deposition of the chromium (Cr) depends on the height and the width of the remaining photoresist 20 and the length of the metallic film 19 protruding from under the overlying photoresist 20, but in general, the angle is in the range of between 10 to 80 degrees.

The surface acoustic wave transducer with closely spaced electrode segments according to the present invention is structured as described above. Hence, the structure of the present invention is very effective in preventing short-circuiting of adjacent electrode segments in the manufacture of a resonator which is required to have a high resonance frequency, or a unidirectional transducer, in which the electrode segments are wide but closely spaced apart for easy fabrication. With the manufacturing method of the present invention, partitions of a dielectric material can each be provided between adjacent electrode segments in the step of their formation. Further, since the IDT electrode segments are mostly formed as a unitary structure, they can be made dielectric at required positions at one time by anodic oxidation. Accordingly, the method of the present invention permits easy and low-cost fabrication of the transducers mentioned above.

### AVAILABILITY FOR INDUSTRIAL APPLICATIONS

As described above, the structure for preventing short-circuiting between adjacent electrode segmens and the manufacturing method according to the present invention effectively prevents the short of the electrodes segments in surface acoustic wave transducers in which IDT electrode segments (including floating electrodes, meander lines, or reflecting strips) are closely spaced apart or their spacing is small as compared with the width of each segment. Moreover, the structure and the manufacturing method according to the present invention allows ease in the manufacture of such transducers and improves the yield rate of their fabrication.

## Claims

1. A structure of a surface acoustic wave transducer in which IDT (Inter-Digital Transducer) electrode segments themselves, or such segments and a floating electrode or meander line disposed therebetween, or reflecting strips (hereinafter referred to as electrode segments) are closely spaced apart, characterized in that only the marginal edges of at least one of adjacent metallic electrode segments are rendered dielectric by oxidation or anodization to prevent short-circuiting therebetween and that letting the width of each of adjacent IDT electrodes and their spacing be represented by L and S, respectively, S/L « 1.

2. A structure for a surface acoustic wave transducer in which adjacent IDT electrode segments are slightly spaced apart and only one marginal edge of one of said adjacent electrode segments defines a substantially U-shaped cavity between it and the surface of a piezoelectric substrate on which said electrode segments mounted, characterized in that only the marginal edge of the other electrode segment is oxidized or anodized to form thereon a metal oxide to fill said cavity with said metal oxide to prevent short-circuiting between said electrode segments and that letting the width of each of said adjacent IDT electrode segments and their spacing be represented by L and S, respectively, S«L.

3. The structure of a surface acoustic wave transducer having closely spaced-apart electrode segments according to claims 1, 2 and 3, characterized in that said metallic film deposited first and said metallic film deposited next are formed of different materials.

4. A method for the manufacture of a surface acoustic wave transducer having closely spaced-apart electrode segments, comprising the steps of:
a) depositing a metallic film over a required area of the surface of a piezoelectric substrate;
b) depositing photoresist all over said metallic film;
c) exposing said photoresist to light at requird intervals and developing said photoresist to remove its exposed portions;
d) etching away said metallic film exposed between the remaining portions of said photoresist;
characterized by
e) rendering the marginal edges of the metallic film underlying said remaining photoresists dielectric by oxidation or anodization;
f) depositing a metallic film onto the surface of said remaining photoresist and the expose surface of said piezoelectric substrate, and
g) removing said remaining photoresist and said metallic film deposited thereon

5. A method for the manufacture of surface acoustic wave transducer which has closely spaced-apart electrode segments and in which a substantially U-shaped cavity defined between at least on marginal edge of each electrode segment and the surface of a piezoelectric substrate having deposited it thereon is filled with dielectric material, said method comprising the steps of:
a) depositing a metallic film over a required area of said substrate surface;
b) depositing photoresist all over said metallic film;
c) exposing said photoresist to light at requires intervals and developing said photoresist to remove its exposed portions;
characterized by
d) depositing a thin film of a material resistant to an etchant for said metallic film onto the surface and one side of said remaining photoresist from a direction oblique to said substrate surface;
e) etching away the expose portions of said metallic film deposited on said substrate surface between the remaining portions of said photoresist;
f) etching away said thin film, leaving said metallic film underlying said remaining photoresists and slightly protruding from under one side thereof;
g) rendering the protruding portion of said metallic film dielectric by oxidation or anodization;
h) depositing a metallic film onto the surface of said remaining photoresist, said dielectric portion protruding from under one side marginal edge of said remaining photoresist and the exposed areas of said substrate surface; and
i) removing said remaining photoresists and said metallic film deposited thereon.

6. A method for the manufactor of surface acoustic wave transducer according to claim 4 or 5 characterized in that said metallic film deposited first and said metallic film deposited next are formed of different materials.

## Patentansprüche

1. Ein Aufbau eines Wandlers für akustische Oberflächenwellen, bei denen die IDT (Inter-Digital Transducer-) Elektrodensegmente selbst oder derartige Segmente und eine floatierende Elektrode oder eine zwischen diesen angeordnete Meanderlinie oder reflektierende Streifen (im folgenden als Elektroden Segmente bezeichnet) nahe voneinander beabstandet sind, dadurch gekennzeichnet, daß die äußeren Ränder wenigstens eines benachbarten metallischen Elektrodensegments durch Oxidation oder Anodisation dielektrisch gemacht sind, um Kurzschlüsse zwischen diesen zu vermeiden und daß bei einer Breite jeder der benachbarten IDT-Elektroden oder ihrer Abstände von L bzw. S die Ungleichung S/L « 1 gilt.

2. Ein Aufbau für einen Wandler für akustische Oberflächenwellen, bei denen benachbarte IDT-Elektroden Segmente geringfügig voneinander beabstandet sind und nur ein äußerer Rand eines der benachbarten Elektrodensegmente eine im wesentlichen U-förmige Höhlung zwischen sich und der Fläche eines Piezoelektrischen Substrats, auf der die Elektrodensegmente montiert sind, ausbildet, dadurch gekennzeichnet, daß nur der marginale Rand des anderen Elektrodensegments oxidiert oder anodisiert ist, um darauf ein Metalloxid zu bilden, um die Höhlung mit dem Metalloxid zu füllen, um einen Kurzschluß zwischen den Elektrodensegmenten zu verhindern, und daß bei einer Breite jeder der benachbarten IDT-Elektroden oder ihrer Abstände von L bzw. S die Ungleichung S/L « 1 gilt.

3. Der Aufbau eines Wandlers für akustische Oberflächenwellen mit nahe voneinander beabstandeten Elektrodensegmenten nach den Ansprüchen 1, 2 und 3, dadurch gekennzeichnet, daß der metallische Film, der zunächst abgelagert wird und der metallische Film, der nachfolgend abgelagert wird, aus unterschiedlichen Materialien gebildet sind.

4. Ein Verfahren zur Herstellung eines Wandlers für akustische Oberflächenwellen mit nahe voneinander beabstandeten Elektrodensegmenten mit den folgenden Schritten:
a) Aufbringen eines metallischen Films über einen erforderlichen Bereich der Fläche des piezoelektrischen Substrats;
b) Aufbringen eines Fotowiderstands über den gesamten metallischen Film;
c) Belichten des Fotowiderstands in erforderlichen Intervallen und Entwickeln des Fotowiderstands, um die belichteten Abschnitte zu entfernen;
d) Wegätzen des metallischen Films, der zwischen den verbleibenden Abschnitten des Fotowiderstands freiliegt;
gekennzeichnet durch
e) Dielektrischmachen der äußeren Ränder des metallischen Films, der unter den verbleibenden Fotowiderständen liegt, durch Oxidation oder Anodisation;
f) Aufbringen eines Metallfilms auf die Fläche des verbleibenden Fotowiderstands und die freiliegende Fläche des fotoelektrischen Substrats, und
g) Entfernen des verbleibenden Fotowiderstands und des darauf abgelagerten metallischen Films.

5. Ein Verfahren zum Herstellen eines Wandlers für akustische Oberflächenwellen mit nahe voneinander beabstandeten Elektrodensegmenten, bei dem eine im wesentlichen U-förmige Höhlung, die zwischen wenigstens einem äußeren Rand jedes Elektrodensegments und der Fläche eines fotoelektrischen Substrats, das diese trägt, ausgebildet ist, mit einem dielektrischen Material gefüllt wird, wobei das Verfahren die folgenden Schritte aufweist:
a) Aufbringen eines metallischen Film über einen erforderlichen Bereich der Substratfläche;
b) Aufbringen eines Fotowiderstands über den gesamten metallischen Film;
c) Freilegen des Fotowiderstands in erforderlichen Intervallen und Entwickeln des Fotowiderstands, um die belichteten Abschnitte zu entfernen;
gekennzeichnet durch
d) Ablagern eines dünnen Films aus einem Material, das gegenüber einem Ätzvorgang für den metallischen Film widerstandsfähig ist auf der Fläche und einer Seite des verbleibenden Fotowiderstands von einer Richtung schräg zu der Substratfläche;
e) Wegätzen der freiliegenden Abschnitte des metallischen Films, der auf das Substrat aufgebracht ist, zwischen den verbleibenden Bereichen des Fotowiderstands;
f) Wegätzen des dünnen Films unter Belassen des metallischen Films, der unter dem verbleibenden Fotowiderstand liegt und etwas unter einer Seite vorragt;
g) Dielektrischmachen des vorragenden Abschnitts des metallischen Films durch Oxidation oder Anodisation;
h) Ablagern eines metallischen Films auf die Fläche des verbleibenden Fotowiderstands, des dielektrischen Bereichs, der von einem seitlichen äußeren Rand des verbleibenden Fotowiderstands vorragt und der belichteten Flächen der Substratfläche; und
i) Entfernen des verbleibenden Fotowiderstands und des darauf abgelagerten metallischen Films.

6. Ein Verfahren für die Herstellung eines Wandlers für akustische Oberflächenwellen nach Anspruch 4 oder 5, dadurch gekennzeichnet, daß der zunächst abgelagerte metallische Film und der nachfolgend abgelagerte metallische Film aus unterschiedlichen Materialien gebildet sind.

## Revendications

1. Structure d'un transducteur à ondes acoustiques de surface dans lequel des segments d'électrode IDT (transducteur inter-digité) même, ou de tels segments et une électrode flottante ou une ligne méandrique disposée entre eux, ou des bandes réfléchissantes (dénommées ci-après segments d'électrode), sont disposés à faible distance les uns des autres, caractérisée en ce que seuls les bords marginaux d'au moins l'un des segments d'électrode métalliques adjacents sont rendus diélectriques par une oxydation ou une anodisation, pour empêcher un court-circuit entre eux, et, en désignant respectivement la largeur de chacune des électrodes IDT adjacentes et de leur espacement par les références L et S, en ayant S/L « 1.

2. Structure d'un transducteur à ondes acoustiques de surface, dans lequel des segments d'électrode IDT adjacents sont légèrement espacés entre eux et seul un bord marginal de l'un des segments d'électrode adjacents définit une cavité sensiblement en forme de U entre lui-même et la surface d'un substrat piézo-électrique, sur lequel sont montés lesdits segments d'électrode, caractérisée en ce que seul le bord marginal de l'autre segment d'électrode est oxydé ou anodisé pour former sur lui un oxyde de métal, pour remplir ladite cavité avec ledit oxyde de métal, afin d'empêcher tout court-circuit entre lesdits segments d'électrode, et en désignant la largeur de chacun desdits segments d'électrode IDT adjacents et leur espacement respectivement par les références L et S, S « L.

3. Structure d'un transducteur à ondes acoustiques de surface ayant des segments d'électrode espacés à faible distance entre eux selon les revendications 1, 2 et 3, caractérisée en ce que ledit film métallique déposé en premier et ledit film métallique déposé ensuite sont constitués de matériaux différents.

4. Procédé de fabrication d'un transducteur à ondes acoustiques de surface ayant des segments d'électrode disposés à faible distance les uns des autres dans lequel :
a) on dépose un film métallique sur une zone requise de la surface d'un substrat piézo-électrique ;
b) on dépose un agent photorésistant sur toute la surface dudit film métallique ;
c) on expose ledit agent photorésistant à la lumière à des intervalles souhaités et on développe ledit agent photorésistant pour éliminer ses parties exposées ;
d) on grave chimiquement ledit film métallique exposé entre les parties restantes dudit agent photorésistant ;
caractérisé par le fait que :
e) on rend diélectriques les bords marginaux du film métallique sous-jacent auxdits agents photorésistants restants, par oxydation ou anodisation ;
f) on dépose un film métallique sur la surface dudit agent photorésistant restant et la surface d'exposition dudit substrat piézo-électrique, et
g) on élimine ledit agent photorésistant restant et ledit film métallique déposé sur ce dernier.

5. Procédé de fabrication d'un transducteur à ondes acoustiques de surface qui comporte des segments d'électrode disposés à faible distance les uns des autres et dans lequel une cavité sensiblement en forme de U, définie entre au moins un bord marginal de chaque segment d'électrode et la surface d'un substrat piézo-électrique, déposé sur ce dernier, est remplie avec un matériau diélectrique, procédé dans lequel :
a) on dépose un film métallique sur une zone souhaitée de ladite surface du substrat ;
b) on dépose un agent photorésistant sur tout ledit film métallique ;
c) on expose ledit agent photorésistant à la lumière à des intervalles souhaités et on développe ledit agent photorésistant pour éliminer ses parties exposées ;
caractérisé par le fait que :
d) on dépose un film mince de matériau résistant à un agent de gravure chimique, pour ledit film métallique, sur la surface et un bord dudit agent photorésistant restant, depuis une direction oblique à ladite surface de substrat ;
e) on grave chimiquement les parties exposées dudit film métallique déposé sur ladite surface de substrat, entre les parties restantes dudit agent photorésistant ;
f) on grave chimiquement ledit film mince, on laisse ledit film métallique sous-jacent auxdits agents photorésistants restants et faisant légèrement saillie depuis l'un de ses bords ;
g) on rend diélectrique la partie saillante dudit film métallique, par oxydation ou anodisation ;
h) on dépose un film métallique sur la surface dudit agent photorésistant restant, ladite partie diélectrique faisant saillie depuis un bord marginal latéral dudit agent photorésistant restant et les zones exposées de ladite surface de substrat ; et
i) on élimine lesdits agents photorésistants restants et ledit film métallique déposé sur ces derniers.

6. Procédé de fabrication d'un transducteur à ondes acoustiques de surface selon la revendication 4 ou 5, caractérisé par le fait que ledit film métallique déposé en premier et ledit film métallique déposé ensuite sont constitués de matériaux différents.
